# EUROPEAN PATENT SPECIFICATION

(11) **EP 2 890 004 B1**
(45) Date of publication and mention of the grant of the patent: **30.11.2016**
(21) Application number: 14020123.7
(22) Date of filing: 29.12.2014
(51) Int. Cl.: H01S 5/0687, H03B 17/00, H04B 10/2507, H01S 5/00

(54) **Method for the improvement of side-mode suppression in the spectrum of an optoelectronic oscillator**
Verfahren zur Verbesserung der Seitenmodenunterdrückung im Spektrum eines optoelektronischen Oszillators
Procédé pour l'amélioration de la suppression des modes latéraux dans le spectre d'un oscillateur optoélectronique

(30) Priority: 30.12.2013 SI 201300449
(43) Date of publication of application: 01.07.2015
(73) Proprietor: Univerza v Ljubljani Fakulteta za elektrotehniko, 1000 Ljubljana (SI); Center odlicnosti za biosenzoriko, instrumentacijo in procesno kontrolo, 5720 Ajdovscina (SI)
(72) Inventor: Bogataj, Luka, 4228 Zelezniki (SI); Vidmar, Matjaz, 5000 Nova Gorica (SI); Batagelj, Bostjan, 1000 Ljubljana (SI); Tratnik, Jurij, 1290 Grosuplje (SI)
(74) Representative: Ivancic, Bojan

(56) References cited:
- CN-A- 103 219 632
- JP-A- 2009 157 044
- US-A1- 2003 160 148
- US-B1- 6 580 532
- ROMISCH S ET AL: "Performance evaluation of an optoelectronic oscillator", IEEE TRANSACTIONS ON ULTRASONICS, FERROELECTRICS AND FREQUENCY CONTROL, IEEE, US, vol. 47, no. 5, 30 September 2000 (2000-09-30), pages 1159-1165, XP011438190, ISSN: 0885-3010, DOI: 10.1109/58.869060
- OLUKAYODE OKUSAGA ET AL: "Spurious-mode suppression in optoelectronic oscillators", FREQUENCY CONTROL SYMPOSIUM (FCS), 2010 IEEE INTERNATIONAL, IEEE, PISCATAWAY, NJ, USA, 30 June 2010 (2010-06-30), pages 539-543, XP031738460, ISBN: 978-1-4244-6399-2

## Description

The present invention relates to a method for the improvement of side-mode suppression oscillations of an optoelectronic oscillator comprising an optical section and electrical section, wherein said optical section comprises a modulated light source, for example a laser, the Mach-Zehnder's modulator, from which a light fibre is led to a photo detector, and wherein the electrical section comprises an amplifier in series connected to said photo detector, a band-pass filter and a splitter of an electrical signal at the output of the oscillator and the modulation input of the previously mentioned Mach-Zehnder's modulator.

Optoelectronic oscillator has been disclosed in US 6 580 532 B1 and includes techniques that use an optical delay element and an electrical interferometer to facilitate reduction of phase noise in a carrier generator. However, said known solution does not allow a selective reduction of phase noise with regard to the frequency range.

It is the object of the present invention to create an optoelectronic oscillator in which the deficiencies of already known solutions are eliminated.

According to the invention, the object as set above is solved by the features given in the characterizing part claim 1. Details of the invention are disclosed in the sub-claims.

The invention is described in more detail on the basis of a non-limiting embodiment and with reference to the accompanying drawings, wherein:

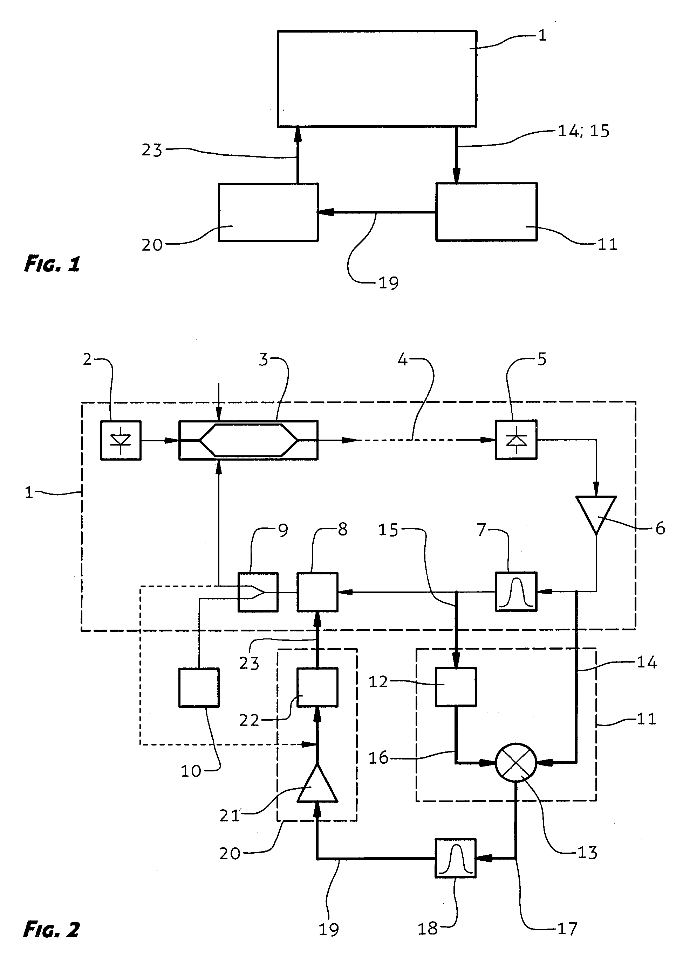

- Fig. 1: shows a schematic view of an optoelectronic oscillator with improved suppression of the side-mode oscillations according to the invention,
- Fig. 2: a more detailed embodiment of the oscillator of Fig. 1.

Description given below is based on one of the possible embodiments of the invention, particularly on an optoelectronic oscillator 1, comprising a modulated light source 2, for example, a laser light source which transmits light in to a Mach-Zehnder's modulator 3, from which light travels through a light fibre 4 to a photo detector 5. Said photo detector 5 converts received light into an electrical signal, which is led into an amplifier 6, in a series-connected band-pass filter 7, a phase shifter 8 and, finally, to a splitter 9. The splitter 9 sends the first part of said signal to an output 10 of the oscillator 1 and the second part of said signal to a modulation input of the Mach-Zehnder's modulator 3. According to the invention, method detects value of the free spectral range of the optoelectronic oscillator and the power of the side-mode oscillations of the oscillator.

The solution according to the present invention observes a distance between generations of oscillations of the optoelectronic oscillator 1. In order to increase suppression of the side-mode oscillations of said oscillator 1 or eliminate influence of side-mode oscillations to the greatest possible extent, a loop is attached. This loop determines the frequency difference between generations of the oscillator 1 or free spectral range. In the present embodiment, attenuation of the side-mode oscillations increases in a way that compares at least one signal 14; 15 taken from the oscillator 1 which is further led to a detector 11 of the free spectral range. Said detector 11 is used for determination of a value of free spectral range by means of at least one signal 14; 15, wherein the previously mentioned detector 11 generates signal, corresponding to the value of the free spectral range and power of the signal of the oscillator's nearest side-mode oscillation.

Said loop is designed in a way that the detector 11 of the free spectral range is in parallel connected to the oscillator 1. In the present embodiment, said detector 11 is connected to the oscillator 1 in the area of the band-pass filter 7. At the point immediately before the entry of an input signal into said band-pass filter 7, the first regulation signal 14 is taken and, at the point immediately after the exit of an output signal from the band-pass filter 7, the second regulation signal 15 is taken, wherein said regulation signals 14, 15 are led to the previously mentioned detector 11. In the present embodiment, case detector 11 comprises at least a frequency mixer 13, and, optionally, a phase shifter 12. In described embodiment, said second regulation signal 15 is led into said phase shifter 12 where the regulation signal 15 is phase shifted according to said first regulation signal 14. As a result a phase shifted regulation signal 16 is obtained which is further led into said mixer 13. Said phase shifter 12 may be located in the section of said first regulation signal 14 since it is only important that mutually phase shifted signals enter the frequency mixer 13. Furthermore, said first regulation signal 14 is led directly into the previously mentioned mixer 13, where it combines with said phase shifted second regulation signal 16. The frequency mixer 13 compares said input signal and said output signal of the band-pass filter. Since the previously mentioned mixer 13 compares signals with the same frequency, a frequency spectrum is translated into the basic frequency band. As a result, also other side-mode oscillations are translated, which serves as the basis for a modulation signal of the phase shifter in said loop of an optoelectronic oscillator. The result of the merger of the signals 14, 16 in the mixer 13 is an electrical modulation signal 17 with a frequency, which is equal to the free spectral range (FSR) or frequency spacing between side-mode oscillations.

The electrical modulation signal 17 exiting from said detector 11 is further led into a band-pass filter 18 having a central frequency equal to the approximate value of the free spectral range. This prevents influence of the interference signals to the phase detector 8 and ensures that a signal 19 is affected only by the side generations of oscillations of the oscillator. Power and phase of the modulation signal 19 exiting from said band-pass filter 18 have to be adjusted in a way that the signal caused by the phase shifter 8 in an oscillator's loop is subtracted from the side-mode oscillations of the optoelectronic oscillator 1. Therefore, the previously mentioned signal is led to an adapter of power and phase 20 which in the present embodiment comprises a receiver 21, which amplifies said signal 19 and a phase shifter 22 in series connected to the receiver 21, which rotates the phase of said signal 19. The control signal 23 exiting from said power and phase adapter 20 is led into said phase shifter 8 of the oscillator 1, where the signal thereof is phase-modulated, thereby causing attenuation of the side-mode oscillations. Reduction of the first side-mode oscillation effects also the reduction of all following side-mode oscillations.

## Claims

1. A method for the improvement of side-mode suppression oscillations of an optoelectronic oscillator (1) comprising an optical section and an electrical section, wherein said optical section comprises a modulated light source (2), for example a laser, a Mach-Zehnder's modulator (3) from which a light fibre (4) leads to a photo detector (5), and wherein the electrical section comprises an amplifier (6) in series connected to the photo detector (5), a band-pass filter (7), and splitter (9) of the electrical signal to the output of the oscillator (1) and to the modulation input of said Mach-Zehnder's modulator (3), ***characterised in that*** the side-mode oscillations of an optoelectronic oscillator (1) are suppressed by a loop (11, 18, 19) connected to said oscillator (1), which determines the frequency difference between generations of the oscillator (1) or free spectral range, and controls a phase shifter (8) of the oscillator (1), wherein said control of the phase shifter (8) of the oscillator (1) comprises the following steps:
a) leading at least one signal (14; 15) from any point of the electrical section of the optoelectronic oscillator (1) whose side-mode oscillations are necessary to be attenuated, to a detector (11) of a free spectral range;
b) determining the value of the free spectral range of at least one of said signals (14; 15) by said detector (11), wherein said detector (11) generates a signal corresponding to the value of the free spectral range and to the power of the side-mode oscillation which is nearest to the oscillator's signal;
c) leading a signal (17) coming out of said detector (11) of the free spectral range into a band-pass filter (18) which passes only a search frequency spacing between side-modes;
d) leading of a signal (19) coming out of said band-pass filter (18) into an adapter of power and phase (20) which assigns the necessary power and phase to the signal;
e) sending a control signal (23) from the adapter of power and phase (20) to said phase shifter (8) of the oscillator (1).

2. A method according to claim 1, ***characterised in that*** the voltage and/or frequency and/or amplitude corresponding to the side-mode oscillation is adapted to said signal (17).

3. A device comprising the apparatus features as defined in claim 1 for carrying out the method according to claims 1 to 2, ***characterized in* that** said loop (11, 18, 19) is configured in a manner that said band-pass filter (7) is in parallel connected to the detector (11) of free spectral range, which is in series connected to the band-pass filter (18) and the adapter of power and phase (20), which sends the control signal (23) to said phase shifter (8) of the oscillator (1), thereby causing suppression of side-mode oscillations.

4. A device according to claim 3, ***characterized in that*** the detector (11) of free spectral range comprises a phase shifter (12) and a frequency mixer (13).

5. A device according to claim 3, ***characterized in that*** the adapter of power and phase (20) comprises an amplifier (21) and a phase shifter (22).

## Patentansprüche

1. Verfahren zur Verbesserung der Unterdrückung von Nebenmodenoszillationen eines optoelektronischen Oszillators (1) mit einem optischen Bereich und einem elektrischen Bereich, wobei der optische Bereich eine modulierte Lichtquelle (2), beispielsweise einen Laser, und einen Mach-Zehnder-Modulator (3) umfasst, von dem ein Lichtleitkabel (4) zu einem Fotodetektor (5) verläuft, und wobei der elektrische Bereich einen Verstärker (6), der seriell mit dem Fotodetektor (5) verbunden ist, einen Bandpassfilter (7) und einen Splitter (9) des elektrischen Signals zur Ausgabe des Oszillators (1) und zur Modulationseingabe des Mach-Zehnder-Modulators (3) umfasst, **dadurch gekennzeichnet, dass** die Nebenmodenoszillation eines optoelektronischen Oszillators (1) durch eine Schleife (11, 18, 19) unterdrückt werden, die mit dem Oszillator (1) verbunden ist und den Frequenzunterschied zwischen Generationen des Oszillators (1) oder des freien Spektralbereichs bestimmt und einen Phasenschieber (8) des Oszillators (1) kontrolliert, wobei die Kontrolle des Phasenschiebers (8) des Oszillators (1) die folgenden Schritte umfasst:
a) Führen von mindestens einem Signal (14, 15) von einem Punkt des elektrischen Bereichs des optoelektronischen Oszillators (1), dessen Nebenmodenoszillation abgeschwächt werden sollen, zu einem Detektor (11) eines freien Spektralbereichs;
b) Bestimmen des Werts des freien Spektralbereichs von mindestens einem der Signale (14, 15) durch den Detektor (11), wobei der Detektor (11) ein Signal entsprechend dem Wert des freien Spektralbereichs und entsprechend der Leistung der Nebenmodenoszillation erzeugt, welche dem Oszillatorsignal am nächsten gelegen ist;
c) Führen eines aus dem Detektor (11) ausgegebenen Signals (17) des freien Spektralbereichs in einen Bandpassfilter (18), der lediglich durchlässig für eine Suchfrequenz ist, die zu den Nebenmoden beanstandet ist;
d) Führen eines durch besagten Bandpassfilter (18) durchgelassen Signals (19) in einen Leistungs- und Phasenadapter (20), welcher die notwendige Leistung und Phase dem Signal zuordnet;
e) Senden eines Kontrollsignals (23) von dem Leistungs- und Phasenadapter (20) zu dem Phasenschieber (8) des Oszillators (1).

2. Verfahren nach Anspruch 1, **dadurch gekennzeichnet, dass** die Spannung und/oder Frequenz und/oder Amplitude den Nebenmodenoszillation entsprechend dem besagten Signal angepasst sind.

3. Vorrichtung mit den in Anspruch 1 beschriebenen Vorrichtungsmerkmalen zum Durchführen des Verfahrens nach Anspruch 1 und Anspruch 2, **dadurch gekennzeichnet, dass** die Schleife (11, 18, 19) in einer Weise konfiguriert ist, dass der Bandpassfilter (7) mit dem Detektor (11) des freien Spektralbereichs parallel geschaltet ist, welcher zum Bandpassfilter (18) und zum Leistungs- und Phasenadapter (20) seriell geschaltet ist, welcher das Kontrollsignal (23) zu dem Phasenschieber (8) des Oszillators (1) sendet und dadurch die Unterdrückung der Nebenmodenoszillationen erreicht.

4. Vorrichtung nach Anspruch 3, **dadurch gekennzeichnet, dass** der Detektor (11) des freien Spektralbereichs eine Phasenschieber (12) und einen Frequenzmischer (13) umfasst.

5. Vorrichtung nach Anspruch 3, **dadurch gekennzeichnet, dass** der Leistungs- und Phasenadapter (20) einen Verstärker (21) und einen Phasenschieber (22) umfasst.

## Revendications

1. - Procédé pour l'amélioration de suppression d'oscillations de modes latéraux d'un oscillateur optoélectronique (1) comprenant une section optique et une section électrique, dans lequel ladite section optique comprend une source de lumière modulée (2), par exemple un laser, un modulateur de Mach-Zehnder (3) à partir duquel une fibre optique (4) mène à un photodétecteur (5), et dans lequel la section électrique comprend un amplificateur (6) connecté en série au photodétecteur (5), un filtre passe-bande (7), et un coupleur (9) du signal électrique vers la sortie de l'oscillateur (1) et vers l'entrée de modulation dudit modulateur de Mach-Zehnder (3), ***caractérisé par le fait que*** les oscillations de modes latéraux d'un oscillateur optoélectronique (1) sont supprimées par une boucle (11, 18, 19) connectée audit oscillateur (1), qui détermine la différence de fréquence entre des générations de l'oscillateur (1) ou une plage spectrale libre, et commande un déphaseur (8) de l'oscillateur (1), ladite commande du déphaseur (8) de l'oscillateur (1) comprenant les étapes suivantes:
a) la conduite d'au moins un signal (14; 15) en provenance d'un point quelconque de la section électrique de l'oscillateur optoélectronique (1) dont il est nécessaire d'atténuer les oscillations de modes latéraux, vers un détecteur (11) d'une plage spectrale libre;
b) la détermination de la valeur de la plage spectrale libre d'au moins un desdits signaux (14; 15) par ledit détecteur (11), ledit détecteur (11) générant un signal correspondant à la valeur de la plage spectrale libre et à la puissance de l'oscillation de modes latéraux qui est la plus proche du signal de l'oscillateur;
c) la conduite d'un signal (17) sortant dudit détecteur (11) de la plage spectrale libre dans un filtre passe-bande (18) qui laisse passer seulement un espacement de fréquence de recherche entre des modes latéraux;
d) la conduite d'un signal (19) sortant dudit filtre passe-bande (18) dans un adaptateur de puissance et de phase (20) qui affecte les puissance et phase nécessaires au signal;
e) l'envoi d'un signal de commande (23) en provenance de l'adaptateur de puissance et de phase (20) audit déphaseur (8) de l'oscillateur (1).

2. - Procédé selon la revendication 1, ***caractérisé par le fait que*** la tension et/ou la fréquence et/ou l'amplitude correspondant à l'oscillation de modes latéraux est/sont adaptées audit signal (17).

3. - Dispositif comprenant les caractéristiques d'appareil telles que définies à la revendication 1 pour réaliser le procédé selon les revendications 1 à 2, ***caractérisé par le fait que*** ladite boucle (11, 18, 19) est configurée de telle manière que ledit filtre passe-bande (7) est connecté en parallèle au détecteur (11) de plage spectrale libre, qui est connecté en série au filtre passe-bande (18) et à l'adaptateur de puissance et de phase (20), qui envoie le signal de commande (23) audit déphaseur (8) de l'oscillateur (1), provoquant ainsi une suppression d'oscillations de modes latéraux.

4. - Dispositif selon la revendication 3, ***caractérisé par le fait que*** le détecteur (11) de plage spectrale libre comprend un déphaseur (12) et un mélangeur de fréquences (13).

5. - Dispositif selon la revendication 3, ***caractérisé par le fait que*** l'adaptateur de puissance et de phase (20) comprend un amplificateur (21) et un déphaseur (22).
